# EUROPEAN PATENT APPLICATION

(11) **EP 4 539 618 A1**
(43) Date of publication of application: **16.04.2025**
(21) Application number: 23820159.4
(22) Date of filing: 12.06.2023
(51) Int. Cl.: H05K 3/28, H05K 3/10, H01L 23/13, H01L 23/498, H01L 23/00

(54) **CIRCUIT BOARD, AND SEMICONDUCTOR PACKAGE COMPRISING SAME**

(30) Priority: 10.06.2022 KR 20220070917
(71) Applicant: LG INNOTEK CO. LTD, Gangseo-gu Seoul 07796 (KR)
(72) Inventor: NA, Se Woong, Seoul 07796 (KR); KIM, Sang Il, Seoul 07796 (KR); LEE, Kee Han, Seoul 07796 (KR)
(74) Representative: M. Zardi & Co S.A.
(86) International application number: PCT/KR2023/008033
(87) International publication number: WO 2023/239224

(57) **Abstract**

A circuit board according to an embodiment an insulating layer; a first circuit pattern disposed on the insulating layer; and a first protective layer disposed on the insulating layer and including a first open portion vertically overlapping the first circuit pattern, wherein the first protective layer includes a first region including the first open portion and having a first thickness, and a second region having a second thickness greater than the first thickness without including the first open portion, wherein the first thickness of the first region is smaller than a third thickness of the first circuit pattern, and wherein an inner side surface of the first region constituting the first open portion includes a first inner side surface in direct contact with an outer side surface of the first circuit pattern, and a second inner side surface spaced apart from the outer side surface of the first circuit pattern.

## Description

### [Technical Field]

An embodiment relates to a circuit board and a semiconductor package including the same.

### [Background Art]

The miniaturization, weight reduction, and integration of electronic components are accelerating, and accordingly, A circuit line width is becoming smaller. In particular, design rules of semiconductor chips are being integrated on a nanometer scale, and accordingly, the circuit line width of a package substrate or circuit board on which the semiconductor chip is mounted is becoming smaller to several micrometers or less.

Various methods have been proposed to increase the circuit integration of the circuit board (i.e., to minimize the circuit line width). For example, a SAP (semi-additive process) method and a MSAP (modified semi-additive process) method have been proposed to prevent a loss of the circuit line width during an etching process to form a pattern after copper plating.

Since then, an embedded trace substrate (ETS) method, which embeds copper foil within an insulating layer, has been used in the industry to implement a finer circuit pattern. The ETS method is a type of manufacturing method in which a copper circuit is embedded within the insulating layer instead of being formed by protruding the copper circuit onto the surface of the insulating layer. Accordingly, there is no circuit loss due to etching, which is advantageous in minimizing a circuit pitch.

Meanwhile, a chip is mounted on the circuit board as described above, or the circuit board is combined with a main board of an external device to form a package substrate.

To this end, a groove is formed in a protective layer disposed at an outermost side of the circuit board, and a solder ball for mounting the chip or combining the main board is disposed in the groove. In addition, the package substrate can be manufactured by mounting a chip on the solder ball or combining a main board, and then forming a molding layer.

However, according to a prior art, when the solder ball is disposed on the circuit board, an intermetallic compound (IMC) is formed between the solder ball and a metal layer combined with the solder ball. At this time, when a molding liquid for forming the molding layer is injected in a process of manufacturing the package substrate, there is a problem that damage due to a molding liquid injection pressure is transmitted to the intermetallic compound (IMC), and thus cracks occur in the intermetallic compound (IMC). In addition, when a crack occurs in the intermetallic compound (IMC), a reliability problem occurs in which the chip or the main board is separated from the circuit board due to separation of the intermetallic compound (IMC).

Accordingly, there is a need for a structure capable of minimizing the damage transmitted to the intermetallic compound (IMC) by the molding liquid injection pressure.

### [Disclosure]

### [Technical Problem]

The embodiment provides a circuit board having a novel structure and a semiconductor package including the same.

In addition, the embodiment provides a circuit board capable of improving reliability of an intermetallic compound (IMC) and a semiconductor package including the same.

In addition, the embodiment provides a circuit board capable of increasing a contact area between a connection part and a pad and a semiconductor package including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment comprises an insulating layer; a first circuit pattern disposed on the insulating layer; and a first protective layer disposed on the insulating layer and including a first open portion vertically overlapping the first circuit pattern, wherein the first protective layer includes a first region including the first open portion and having a first thickness, and a second region having a second thickness greater than the first thickness without including the first open portion, wherein the first thickness of the first region is smaller than a third thickness of the first circuit pattern, and wherein an inner side surface of the first region constituting the first open portion includes a first inner side surface in direct contact with an outer side surface of the first circuit pattern, and a second inner side surface spaced apart from the outer side surface of the first circuit pattern.

In addition, the second inner side surface of the first region is connected to the first inner side surface of the first region and has a slope corresponding to a slope of the first inner side surface.

In addition, the second thickness of the second region is greater than the third thickness of the first circuit pattern.

In addition, the first circuit pattern includes a region whose width decreases toward an upper surface of the first circuit pattern, and the second inner side surface of the first region is spaced apart from an outer side surface of the region of the first circuit pattern whose width decreases.

In addition, the first thickness of the first region satisfies a range of 20% to 90% of the third thickness of the first circuit pattern.

In addition, the first circuit pattern includes a first part disposed on an upper surface of the insulating layer and having an outer side surface in contact with the first inner side surface of the first region; and a second part disposed on the first part and having an outer side surface that does not contact the first protective layer, and wherein the second part includes a region having a width smaller than a width of the first part.

In addition, a width of the first open portion corresponds to a width of the first part.

In addition, the first part has a fourth thickness in a range of 20% to 90% of the first thickness of the first region.

In addition, the outer side surface of the second part has a linear slope whose width gradually decreases toward an upper surface of the second part.

In addition, the outer side surface of the second part has a curved slope with a specific curvature whose width decreases toward an upper surface of the second part.

In addition, a width of the second part closest to the first part is smaller than a width of the first part closest to the second part, and the first circuit pattern includes a step portion provided between the first part and the second part.

In addition, the outer side surface of the second part has a slope in which the width decreases toward the upper surface of an second part or a slope in which the width does not change toward an upper surface of the second part.

In addition, the second part includes a first sub-part having an outer side surface having a first slope and a second sub-part having an outer side surface having a second slope different from the first slope.

In addition, the first protective layer includes a recessed portion provided at the boundary between the first region and the second region and recessed in an inward direction of the first protective layer.

In addition, the circuit board further includes a surface treatment layer disposed on the first circuit pattern, and a lowermost end of the surface treatment layer is positioned lower than an upper surface of the first region.

In addition, at least a part of the surface treatment layer is in contact with the second inner side surface of the first region.

In addition, a surface roughness of an outer side surface of the first part is different from a surface roughness of an outer side surface of the second part.

Meanwhile, a semiconductor package according to an embodiment comprises: an insulating layer; a first circuit pattern disposed on the insulating layer; a first protective layer disposed on the insulating layer and including a first open portion vertically overlapping the first circuit pattern; a first connection part disposed on the first circuit pattern vertically overlapping the first open portion of the first protective layer; and a semiconductor device mounted on the first connection part, wherein the first protective layer includes a first region including the first open portion and having a first thickness, and a second region having a second thickness greater than the first thickness without including the first open portion, the first thickness of the first region is smaller than a third thickness of the first circuit pattern, a crevice is formed between an inner side surface of the first region constituting the first open portion and an outer side surface of the first circuit pattern, and at least a portion of the first connection part is disposed in the crevice.

In addition, the first protective layer includes a recessed portion provided at a boundary between the first region and the second region and formed in an inward direction of the first protective layer, and at least a portion of the first connection part is disposed in the recessed portion.

### [Advantageous Effects]

The embodiment includes an insulating layer, a first circuit pattern disposed on the insulating layer, and a first protective layer disposed on the insulating layer and including a first open portion vertically overlapping the first circuit pattern.

That is, the first protective layer includes a first region adjacent to the first open portion and including the first open portion. In addition, the first protective layer includes a second region adjacent to the first region. At this time, a height of an upper surface of the first region is lower than a height of an upper surface of the second region. Preferably, the height of the upper surface of the first region is lower than a height of an upper surface of the first circuit pattern. Accordingly, the embodiment arranges the first protective layer including the first region having the first open portion and the second region in a region where the protective layer is not disposed due to an exposure resolution of the protective layer. In addition, the first region is disposed surrounding the first circuit pattern while including the first open portion having substantially a same width as the first circuit pattern.

Accordingly, the embodiment can stably protect the first circuit pattern from damage caused by various stresses. Accordingly, the embodiment can improve physical reliability and/or electrical reliability of the first circuit pattern.

At this time, a crevice can be formed between an inner side surface of the first region of the first protective layer and an outer side surface of the first circuit pattern.

Specifically, the inner side surface of the first region includes a first inner side surface in contact with an outer side surface of the first circuit pattern and a second inner side surface spaced apart from the outer side surface of the first circuit pattern by the crevice without contacting the outer side surface of the first circuit pattern.

In addition, the embodiment allows a surface treatment layer and/or solder to be disposed in the crevice. Accordingly, the embodiment can increase a distance between an intermetallic compound formed by disposing a solder and an uppermost surface of the first protective layer. Accordingly, the embodiment can drastically reduce the occurrence of cracks in the intermetallic compound, thereby improving the physical reliability and/or electrical reliability of a circuit board and a semiconductor package.

Furthermore, the embodiment can increase the distance by using the clevis without increasing a thickness of the first protective layer. Therefore, the embodiment can realize slimming of the circuit board and the semiconductor package.

In addition, the outer side surface of the first circuit pattern includes a first outer side surface that contacts the outer side surface of the first region of the first protective layer, and a second outer side surface that does not contact the first protective layer. In addition, a surface roughness of the second outer side surface can be greater than a surface roughness of the first outer side surface. Accordingly, the embodiment can secure adhesion between a surface treatment layer disposed on the second outer side surface and the first circuit pattern, and thereby improve the physical reliability and/or electrical reliability of the circuit board and the semiconductor package including the same.

In addition, the embodiment allows a recessed portion to be formed inwardly at a boundary between the first region and the second region by controlling a thickness of the first region. In addition, the recessed portion can be filled with a connection part, such as solder, in a process of bonding the solder. In addition, the connection part disposed in the recessed portion can function as an anchor, thereby improving a bonding strength between the connection part and the first circuit pattern.

### [Description of Drawings]

FIG. 1 is a view showing a circuit board according to a comparative example.
FIG. 2 is a view for explaining a reliability problem of an intermetallic compound (IMC) in the comparative example of FIG. 1.
FIG. 3 is a cross-sectional view showing a circuit board according to an embodiment.
FIG. 4 is a plan view showing a first circuit pattern provided in the circuit board of FIG. 3.
FIG. 5 is a cross-sectional view showing a first open portion of a first protective layer and a first circuit pattern according to a first embodiment.
FIG. 6 is a cross-sectional view showing a state in which a surface treatment layer is disposed on the first circuit pattern of FIG. 5.
FIG. 7 is a cross-sectional view showing a second open portion of a first protective layer and a second circuit pattern according to an embodiment.
FIG. 8 is a view showing a circuit board according to a second embodiment.
FIG. 9 is a view showing a circuit board according to a third embodiment.
FIG. 10 is a view showing a circuit board according to a fourth embodiment.
FIG. 11 is a view showing a circuit board according to a fifth embodiment.
FIG. 12 is a cross-sectional view showing a semiconductor package according to an embodiment.
FIGS. 13 to 18 are cross-sectional views showing a method for manufacturing a circuit board according to an embodiment in orders of processes.

### [Best Mode]

Hereinafter, the embodiment disclosed in the present specification will be described in detail with reference to the accompanying drawings, but the same or similar components are designated by the same reference numerals regardless of drawing numbers, and repeated description thereof will be omitted. The component suffixes "module" and "part" used in the following description are given or mixed together only considering the ease of creating the specification, and have no meanings or roles that are distinguished from each other by themselves. In addition, in describing the embodiments disclosed in the present specification, when it is determined that detailed descriptions of a related well-known art unnecessarily obscure gist of the embodiments disclosed in the present specification, the detailed description thereof will be omitted. Further, the accompanying drawings are merely for facilitating understanding of the embodiments disclosed in the present specification, the technological scope disclosed in the present specification is not limited by the accompanying drawings, and it should be understood as including all modifications, equivalents and alternatives that fall within the spirit and scope of the present invention.

It will be understood that, although the terms "first," "second," etc. may be used herein to describe various elements, these elements should not be limited by these terms. These terms are only used to distinguish one element from another.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (i.e., "between" versus "directly between," "adjacent" versus "directly adjacent," etc.).

As used herein, the singular forms "a," "an" and "the" are intended to include the plural forms as well, unless the context clearly indicates otherwise.

It will be further understood that the terms "comprises," "comprising," "includes" and/or "including," when used herein, specify the presence of stated features, integers, steps, operations, elements, and/or components, but do not preclude the presence or addition of one or more other features, integers, steps, operations, elements, components, and/or groups thereof.

Hereinafter, an embodiment of the present invention will be described in detail with reference to the attached drawings.

### - comparative example -

Before explaining the embodiment, a comparative example will be described in comparison with the circuit board of the embodiment of the present invention.

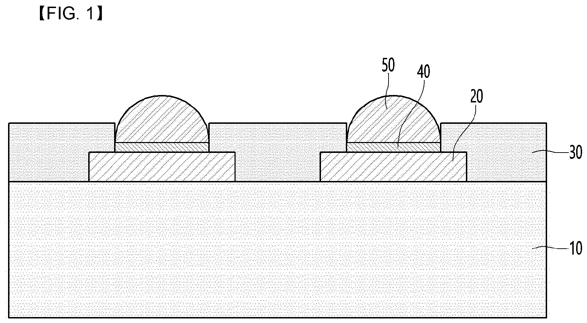

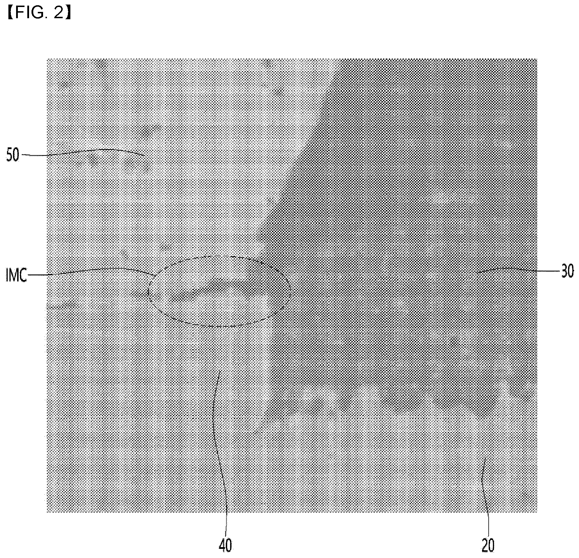

FIG. 1 is a view showing a circuit board according to a comparative example, and FIG. 2 is a view for explaining a reliability problem of an intermetallic compound (IMC) in the comparative example of FIG. 1.

Referring to FIG. 1, the circuit board according to the comparative example includes an insulating layer 10, a circuit pattern layer 20, a protective layer 30, a surface treatment layer 40, and a solder 50.

The circuit board of the comparative example has a structure in which the solder 50 is disposed on the circuit pattern layer 20 to attach a chip (not shown) or an external substrate (not shown).

The circuit board of the comparative example includes an insulating layer 10. In addition, the circuit board of the comparative example includes a circuit pattern layer 20 disposed on the insulating layer 10. The circuit pattern layer 20 includes a pad and a trace. The pad refers to an electrode pattern on which the solder 50 is disposed for bonding with the chip or external substrate among the circuit pattern layers. The trace may refer to a thin signal line connecting the plurality of pads.

In addition, the circuit board of the comparative example includes a protective layer 30 disposed on an insulating layer 10.

The protective layer 30 includes an opening. Specifically, the protective layer 30 partially exposes an upper surface of a pad on which the solder 50 is to be disposed among the circuit pattern layers 20. For example, the opening of the protective layer 30 provides a space on which the solder 50 is to be disposed.

A surface treatment layer 40 is disposed in the opening of the protective layer 30. The surface treatment layer 40 is disposed on the circuit pattern layer 20 that vertically overlaps the opening of the protective layer 30.

The surface treatment layer 40 may have a certain thickness.

Meanwhile, the solder 50 is disposed on the surface treatment layer 40 to fill the opening of the protective layer 30. At this time, the surface treatment layer 40 and the solder 50 are composed of different materials, and an intermetallic compound (IMC) is formed at an interface between the surface treatment layer 40 and the solder 50.

At this time, an upper surface of the protective layer 30 in the comparative example is located adjacent to the intermetallic compound (IMC). At this time, the protective layer 30 contracts and expands due to thermal stress in an usage environment of the circuit board. In addition, the contract and expansion are transferred to the intermetallic compound (IMC) along an upper surface of the protective layer 30 and an inner wall of the opening.

In addition, a process of manufacturing the circuit board includes a process of bonding a chip or a main board of an external device on the solder 50 and a process of forming a molding layer (not shown) for molding the chip or main board. At this time, a process of forming the molding layer is performed by injecting a molding liquid onto the protective layer 30. At this time, a certain pressure is applied to inject the molding liquid during the process of forming the molding layer, and the applied pressure is transmitted to the intermetallic compound (IMC) along the inner wall of the opening of the protective layer 30.

At this time, in the comparative example as described above, the upper surface of the protective layer 30 is positioned adjacent to the intermetallic compound (IMC), and accordingly, the stress or pressure generated is directly transmitted to the intermetallic compound (IMC).

As illustrated in FIG. 2, when the stress or pressure is transmitted to the intermetallic compound (IMC), a crack may occur in the intermetallic compound (IMC) due to the transmitted pressure. In addition, when a crack occurs in the intermetallic compound (IMC), a physical reliability problem occurs in which the solder 50 is separated from the surface treatment layer 40.

In addition, when the solder 50 is separated from the surface treatment layer 40, the chip or main board connected to the solder 50 is also separated from the circuit board, which causes a problem in product reliability.

Furthermore, a function provided by the semiconductor device disposed on the circuit board increases, and accordingly, a number of semiconductor devices disposed on the circuit board or a number of terminals provided in the semiconductor device increases.

Therefore, the circuit pattern layer is required to be miniaturized for mounting the semiconductor device. However, even if the circuit pattern layer is miniaturized, there is a limit to a size of the opening that can be formed in the protective layer 30. Therefore, the size of the opening is determined by an exposure resolution of the protective layer 30. At this time, a minimum size of the opening that can be formed is generally about 50 µm.

Accordingly, a pad connected to the semiconductor device has a problem that it is difficult to be miniaturized due to the limit of the minimum size of the opening.

In addition, recently, in order to implement miniaturization of the pad, the protective layer is not disposed on the pad connected to the semiconductor device. However, traces disposed in a region where the protective layer is not disposed are not protected by the protective layer, and thus physical reliability and/or electrical reliability problems occur.

Accordingly, the embodiment solves the physical reliability problem of the circuit board of the comparative example. Specifically, the embodiment increases a distance between the upper surface of the protective layer and the intermetallic compound (IMC) without increasing the thickness of the circuit board. Specifically, the embodiment increases a length of the inner wall of the opening of the protective layer connecting the upper surface of the protective layer and the intermetallic compound (IMC).

Through this, the embodiment stably protects the intermetallic compound (IMC) from the stress or pressure that occurs, and thus improves the physical reliability of the intermetallic compound (IMC). Through this, the embodiment improves the physical reliability of the intermetallic compound.

Furthermore, the embodiment forms a protective layer including an opening that vertically overlaps the pad while miniaturizing the pad connected to the semiconductor device. Through this, the embodiment enables stable protection of pads or traces disposed in a mounting region of a semiconductor device.

### -Electronic Device-

Before describing the embodiment, an electronic device including a semiconductor package of the embodiment will be briefly described. The electronic device includes a main board (not shown). The main board can be physically and/or electrically connected to various components. For example, the main board can be connected to the semiconductor package of the embodiment. Various semiconductor devices can be mounted in the semiconductor package.

The semiconductor devices can include active devices and/or passive devices. The active devices can be semiconductor chips in the form of integrated circuits (ICs) in which hundreds to millions of devices are integrated into one chip. The semiconductor chips can be logic chips, memory chips, etc. The logic chips can be central processors (CPUs), graphics processors (GPUs), etc. For example, the logic chip may be an AP including at least one of a central processor (CPU), a graphics processor (GPU), a digital signal processor, an encryption processor, a microprocessor, a microcontroller, or an analog-to-digital converter, an application-specific IC (ASIC), or a chip set including a specific combination of the above.

The memory chip may be a stacked memory such as HBM. In addition, the memory chip may include a memory chip such as a volatile memory (e.g., DRAM), a non-volatile memory (e.g., ROM), a flash memory, etc.

Meanwhile, a product group to which the semiconductor package of the embodiment is applied may be any one of a CSP (Chip Scale Package), an FC-CSP (Flip Chip-Chip Scale Package), an FC-BGA (Flip Chip Ball Grid Array), a POP (Package On Package), and a SIP (System In Package), but is not limited thereto.

In addition, the electronic device may be a smart phone, a personal digital assistant, a digital video camera, a digital still camera, a network system, a computer, a monitor, a tablet, a laptop, a netbook, a television, a video game, a smart watch, an automotive, etc. However, the embodiment is not limited thereto, and it may be any other electronic device that processes data.

### - circuit board -

Hereinafter, a circuit board of the embodiment will be described.

The circuit board means a board before a semiconductor device or chip is mounted.

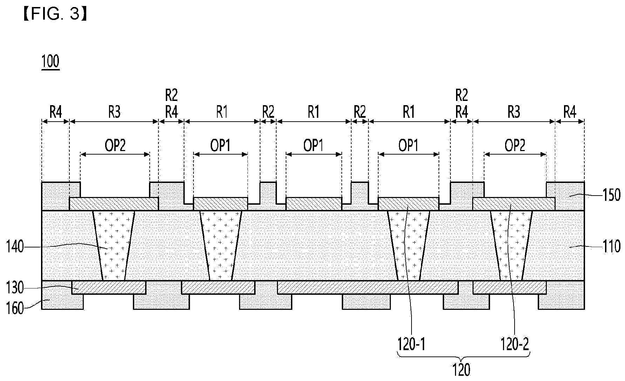

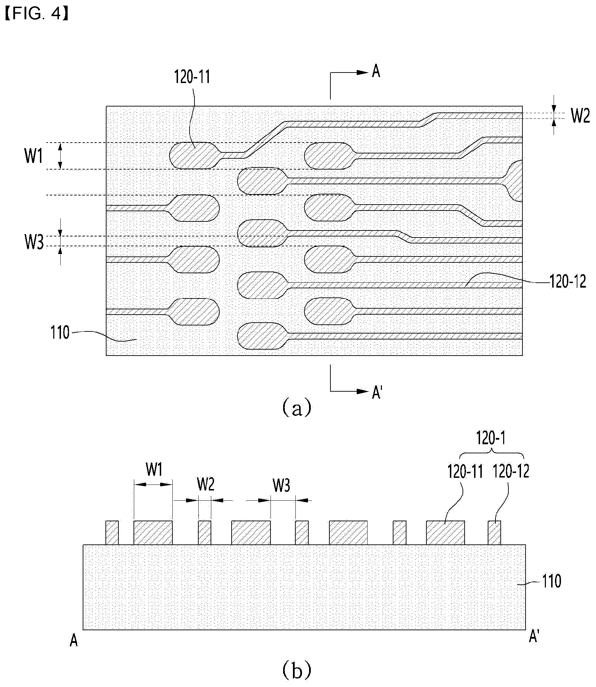

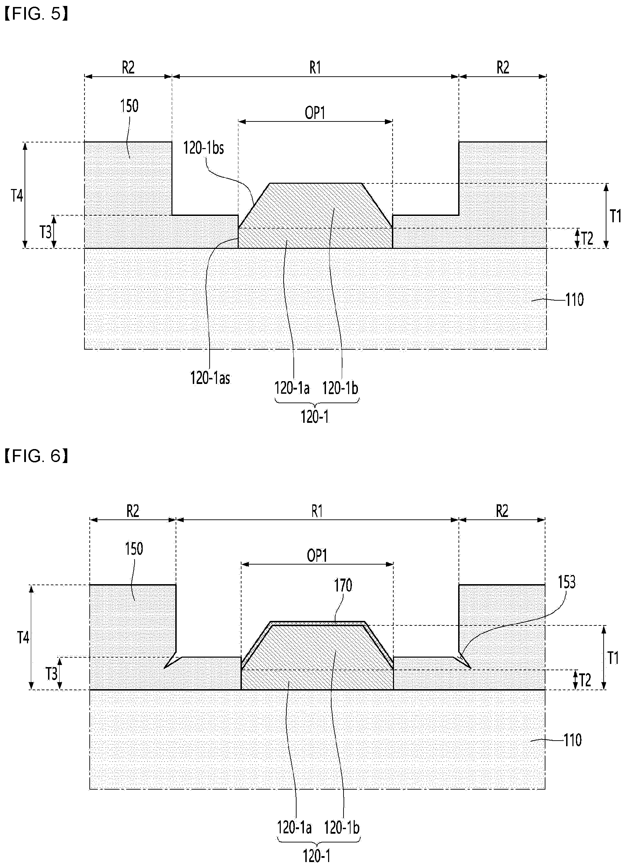

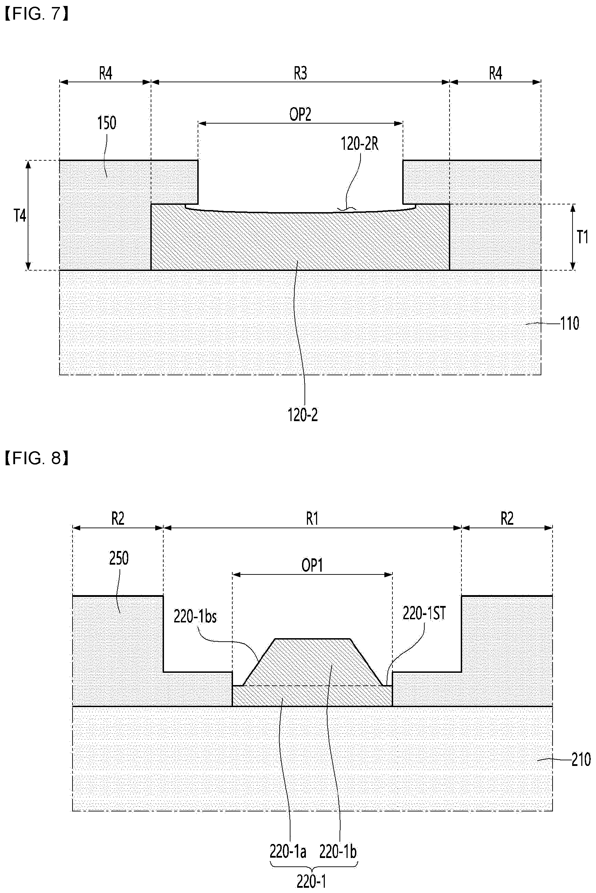

FIG. 3 is a cross-sectional view showing a circuit board according to an embodiment, FIG. 4 is a plan view showing a first circuit pattern provided in the circuit board of FIG. 3, FIG. 5 is a cross-sectional view showing a first open portion of a first protective layer and a first circuit pattern according to a first embodiment, FIG. 6 is a cross-sectional view showing a state in which a surface treatment layer is disposed on the first circuit pattern of FIG. 5, and FIG. 7 is a cross-sectional view showing a second open portion of a first protective layer and a second circuit pattern according to an embodiment.

Hereinafter, a circuit board according to an embodiment will be described with reference to FIGS. 3 to 7.

The circuit board of the embodiment provides a mounting space in which at least one semiconductor device can be mounted.

For example, a circuit board of a first embodiment may provide a mounting space for mounting one semiconductor device, or, alternatively, may provide a plurality of mounting spaces for mounting two or more semiconductor devices.

In addition, one logic chip may be mounted on the circuit board of the first embodiment. In addition, at least two logic chips of different types may be mounted on the circuit board of the first embodiment. In addition, at least one logic chip and at least one memory chip may be mounted on the circuit board of the first embodiment.

Referring to FIG. 3, the circuit board 100 of the first embodiment includes an insulating layer 110. The insulating layer 110 may have one or more layers. Preferably, the insulating layer 110 may have a multilayer structure. At this time, although the insulating layer 110 is illustrated as being composed of one layer in the drawing, the embodiment is not limited thereto. For example, the insulating layer 110 may include a plurality of insulating layers having a structure laminated in a vertical direction.

Hereinafter, the insulating layer 110 is illustrated as one layer and described for convenience of explanation.

The insulating layer 110 may be rigid or flexible.

As an example, the insulating layer 110 may include a prepreg. For example, the insulating layer 110 may be a prepreg in which glass fibers are impregnated into a resin. The resin may be an epoxy resin, but is not limited thereto.

In addition, the insulating layer 110 may include chemically strengthened/semi-strengthened glass such as soda lime glass or aluminosilicate glass. For example, the insulating layer 110 may include a reinforced or flexible plastic such as polyimide (PI), polyethylene terephthalate (PET), propylene glycol (PPG), or polycarbonate (PC). For example, the insulating layer 110 may include sapphire. For example, the insulating layer 110 may include an optically isotropic film. For example, the insulating layer 110 may include COC (Cyclic Olefin Copolymer), COP (Cyclic Olefin Polymer), optically isotropic polycarbonate (PC), or optically isotropic polymethyl methacrylate (PMMA). For example, the insulating layer 110 may be formed of a material including an inorganic filler and an insulating resin. For example, the insulating layer 110 may have a structure in which an inorganic filler of silica or alumina is disposed in a thermosetting resin or a thermoplastic resin. For example, the insulating layer 110 may use ABF (Ajinomoto Build-up Film), FR-4, BT (Bismaleimide Triazine), PID (Photo Imageable Dielectric resin), BT, etc. For example, the insulating layer 110 may include RCC (Resin coated copper).

The insulating layer 110 may have a thickness in a range of 10 um to 60 um. For example, when the insulating layer 110 includes a plurality of layers, each of the plurality of layers may have a thickness in a range of 10 um to 60 um. Preferably, the insulating layer 110 may have a thickness in a range of 15 um to 55 um. More preferably, the insulating layer 110 may have a thickness in a range of 18 um to 52 um.

The thickness of the insulating layer 110 may mean a vertical distance between a plurality of circuit pattern layers disposed adjacent to each other in a thickness direction. For example, the thickness of the insulating layer 110 may mean a vertical distance between a first circuit pattern layer 120 and a second circuit pattern layer 130. For example, the thickness of the insulating layer 110 may mean a vertical distance between a lower surface of the first circuit pattern layer 120 and an upper surface of the second circuit pattern layer 130.

If the thickness of the insulating layer 110 is less than 10 um, warpage characteristics of the circuit board 100 may deteriorate. For example, if the thickness of the insulating layer 110 is less than 10 um, the first circuit pattern layer 120 and the second circuit pattern layer 130 may not be stably disposed on a surface of the insulating layer 110, and thus, electrical reliability and/or physical reliability problems may occur. In addition, if the thickness of the insulating layer 110 is less than 10 um, process characteristics in a process of forming the first circuit pattern layer 120 or the second circuit pattern layer 130 on the insulating layer 110 may deteriorate.

In addition, if the thickness of the insulating layer 110 exceeds 60 um, an overall thickness of the circuit board 100 may increase, and thus, a thickness of the semiconductor package may increase. In addition, if the thickness of the insulating layer 110 exceeds 60 um, it may be difficult to miniaturize the first circuit pattern layer 120 and/or the second circuit pattern layer 130. For example, if the thickness of the insulating layer 110 exceeds 60 um, it may be difficult to form a width of the first circuit pattern layer 120 and/or the second circuit pattern layer 130 and a spacing between adjacent patterns to 12 um or less, 10 um or less, 8 um or less, or 6 um or less. In addition, if it is difficult to miniaturize the first circuit pattern layer 120 and/or the second circuit pattern layer 130, the circuit integration may be reduced, and thus, signal transmission loss may increase due to an increase in a signal transmission distance.

The circuit board 100 of the first embodiment includes a circuit pattern layer disposed on the insulating layer 110.

For example, the circuit board 100 of the first embodiment includes a first circuit pattern layer 120 disposed on an upper surface of the insulating layer 110. In addition, the circuit board 100 includes a second circuit pattern layer 130 disposed on a lower surface of the insulating layer 110.

The first circuit pattern layer 120 may be divided into a plurality of circuit patterns according to location or function.

For example, the first circuit pattern layer 120 may include a first circuit pattern 120-1 and a second circuit pattern 120-2. At least one of the first circuit pattern 120-1 and the second circuit pattern 120-2 may be disposed in a semiconductor device mounting region of the circuit board 100.

For example, at least one of the first circuit pattern 120-1 and the second circuit pattern 120-2 may include a mounting pad connected to a terminal of the semiconductor device.

In addition, at least one of the first circuit pattern 120-1 and the second circuit pattern 120-2 may include a terminal pad coupled to an external substrate.

In addition, at least one of the first circuit pattern 120-1 and the second circuit pattern 120-2 may include a terminal pad coupled to an interposer or a main board of an electronic device. In this case, the interposer may be an active interposer including a semiconductor device function. Alternatively, the interposer may be a passive interposer that performs a signal relay function between a plurality of components.

Meanwhile, the first circuit pattern 120-1 and the second circuit pattern 120-2 can be distinguished from each other by their widths. For example, the first circuit pattern 120-1 can have a width relatively smaller than the second circuit pattern 120-2.

Preferably, the first circuit pattern 120-1 can include a mounting pad connected to a terminal of a semiconductor device. In addition, the second circuit pattern 120-2 can include a terminal pad connected to an external substrate, etc. Therefore, the first circuit pattern 120-1 can be a fine pattern corresponding to the terminal of the semiconductor device.

At this time, functions provided by the semiconductor device disposed on the circuit board increases, and accordingly, a number of semiconductor devices disposed on the circuit board or a number of terminals provided in the semiconductor device increases.

Therefore, miniaturization of the first circuit pattern 120-1 of the first circuit pattern layer 120 is required. However, in the comparative example, there was a limit to miniaturizing the first circuit pattern 120-1 of the first circuit pattern layer 120 due to a problem of the size limit of the open portion of the protective layer, a problem of undercut, and a problem of reliability of the intermetallic compound. That is, if the first circuit pattern 120-1 is miniaturized, there is a problem that an open portion of a size corresponding to a width of the first circuit pattern 120-1 cannot be formed, or a plurality of neighboring patterns are connected to each other by a solder due to the undercut, or reliability of the intermetallic compound is further reduced.

That is, if a spacing between the plurality of patterns of the first circuit pattern 120-1 is reduced, the circuit integration can be improved. However, if the spacing between the plurality of patterns is reduced, a problem may occur in which an open portion corresponding to the plurality of patterns cannot be formed in the first protective layer 150.

In addition, if a width of the first circuit pattern 120-1 decreases or a spacing between a plurality of patterns decreases, a bonding area of the intermetallic compound decreases, and thus physical reliability of the intermetallic compound may be further deteriorated.

Therefore, the embodiment allows the first protective layer 150 to include an open portion while the upper surface of the first protective layer 150 has a step structure. Through this, the embodiment maximizes a distance between an uppermost surface of the first protective layer 150 and the first circuit pattern 120-1. Specifically, a distance between an uppermost surface of the first protective layer 150 and the first circuit pattern 120-1 must be increased in order to improve the physical reliability of the intermetallic compound. To this end, a thickness of the first protective layer 150 may be increased. However, if the thickness of the first protective layer 150 increases, it may be difficult to form an open portion having a size corresponding to the first circuit pattern 120-1 in the first protective layer 150. Furthermore, if the thickness of the first protective layer 150 increases, the thickness of the circuit board increases accordingly, and the overall thickness of the semiconductor package increases accordingly.

Accordingly, in the embodiment, a length of an inner wall of the open portion of the first protective layer 150 provided between the first protective layer 150 and the first circuit pattern 120-1 is increased without increasing the thickness of the first protective layer 150.

This can be achieved by a shape of the open portion of the first protective layer 150 described below and a shape of the first circuit pattern 120-1 vertically overlapping the open portion. This will be described in more detail below.

Meanwhile, when the insulating layer 110 of the circuit board 100 includes a plurality of layers, the first circuit pattern layer 120 may be disposed on an upper surface of an insulating layer positioned at an uppermost side among the plurality of layers of the insulating layer 110, and the second circuit pattern layer 130 may be disposed on a lower surface of an insulating layer positioned at a lowermost side among the plurality of layers of the insulating layer 110. For example, the first circuit pattern layer 120 and the second circuit pattern layer 130 may be illustrated as outer circuit pattern layers, but are not limited thereto.

Meanwhile, when the insulating layer 110 includes a plurality of layers, an additional inner layer circuit pattern layer may be disposed between the plurality of layers.

Referring to FIG. 4, the first circuit pattern 120-1 is disposed in a region where a semiconductor device such as a logic chip is mounted. Accordingly, the first circuit pattern 120-1 may include a fine pattern. FIG. 4 (a) is a plan view showing the first circuit pattern 120-1 in a state where the first protective layer 150 of the embodiment is removed, and FIG. 4 (b) is a cross-sectional view taken along a A-A' direction of FIG. 4 (a).

The first circuit pattern 120-1 includes a pad 120-11 corresponding to a terminal of a semiconductor device or a pad of an interposer, and a trace 120-12 connected to the pad 120-11.

The first circuit pattern 120-1 requires miniaturization. For example, the first circuit pattern 120-1 must be connected to all terminals of a semiconductor device or all pads of an interposer within a limited space, and traces connecting them must be disposed. Accordingly, the first circuit pattern 120-1 may include a fine pattern.

In addition, due to reasons such as 5G, Internet of Things (IoT), increased image quality, and increased communication speed, a number of terminals in the first processor chip and the second processor chip is gradually increasing. Accordingly, one semiconductor device may not provide all functions, or the number of terminals provided in one semiconductor device is increasing.

Accordingly, the first circuit pattern 120-1 may be required to be ultra-fine.

The pad 120-11 of the first circuit pattern 120-1 corresponds to a terminal of the semiconductor device to be mounted on the circuit board. Accordingly, a number of the pads 120-11 corresponds to a number of terminals of the semiconductor device.

The pad 120-11 may have different widths in a first horizontal direction and in a second horizontal direction perpendicular to the first horizontal direction. At this time, the pad 120-11 may have a width in a separation direction of neighboring pads or traces smaller than a width in a direction perpendicular to the separation direction. In addition, the width of the pad 120-11 in the separation direction has a great influence on the circuit integration. The separation direction may mean the first horizontal direction.

That is, the pad 120-11 may have an oval shape in which a width in the first horizontal direction is smaller than a width in the second horizontal direction. However, the embodiment is not limited thereto. For example, the pad 120-11 may have a circular shape having a width in the first horizontal direction as a whole.

The width W1 of the pad 120-11 may be 3 um to 30 um. For example, the width W1 of the pad 120-11 may be 4 um to 28 um. For example, the width W1 of the pad 120-11 may be 5 um to 25 um.

If the width W1 of the pad 120-11 is smaller than 3 um, it may be difficult to dispose a connection part connected to a terminal of the semiconductor device. If the width W1 of the pad 120-11 is smaller than 3 um, connection reliability between the pad 120-11 and the semiconductor device may deteriorate. If the width W1 of the pad 120-11 is greater than 30 um, it may be difficult to dispose all the pads connected to the semiconductor device within a limited space. If the width W1 of the pad 120-11 is greater than 30 um, a size of the circuit board may increase. If the width W1 of the pad 120-11 is greater than 30 um, a spacing between neighboring patterns is narrowed, and thus a reliability problem such as a circuit short may occur.

In addition, the first circuit pattern 120-1 includes a trace 120-12 connected to the pad 120-11. The trace 120-12 may mean a thin and long signal line connected to the pad 120-11. In addition, when two semiconductor devices are mounted on the first circuit pattern 120-1, the trace 120-12 may include a signal line connecting the two semiconductors.

Accordingly, the trace 120-12 may include an ultra-fine pattern. For example, a line width W2 of the trace 120-12 may satisfy a range of 1 um to 10 um. For example, a line width W2 of the trace 120-12 may satisfy a range of 1.2 um to 8 um. For example, a line width W2 of the trace 120-12 can satisfy a range of 1.5 µm to 7 µm. If the line width W2 of the trace 120-12 is smaller than 1 µm, a resistance of the trace 120-12 increases, and thus normal communication with the semiconductor device may be difficult. In addition, if the line width W2 of the trace 120-12 is smaller than 1 µm, it may be difficult to apply a general circuit pattern manufacturing process. If the line width W2 of the trace 120-12 is smaller than 1 µm, a physical reliability problem may occur in which the trace 120-12 collapses due to stress caused by various factors. If the line width W2 of the trace 120-12 is larger than 10 µm, it may be difficult to dispose all signal lines connected to the terminals of the semiconductor device within a limited space. For example, if the line width W2 of the trace 120-12 is greater than 10 µm, it may be difficult to dispose all traces for connecting a plurality of processor chips within a limited space. For example, if the line width W2 of the trace 120-12 is greater than 10 µm, the circuit integration may be reduced.

Meanwhile, the first circuit patterns 120-1 may be spaced apart from each other by a certain spacing W3. The spacing W3 may mean a spacing between pads 120-11 of the first circuit pattern 120-1. In addition, the spacing W3 may mean a spacing between traces of the first circuit pattern 120-1. In addition, the spacing W3 may mean a spacing between the pads 120-11 and traces 120-12 adjacent to each other of the first circuit pattern 120-1.

The spacing W3 may have a range of 1 um to 10 um. The spacing W3 may have a range of 1.2 um to 8 um. The spacing W3 may have a range of 1.5 um to 7 um. If the spacing W3 is smaller than 1 um, there is a problem in that traces or pads adjacent to each other are connected to each other, resulting in an electrical short. For example, if the spacing W3 is greater than 10 um, it may be difficult to dispose all traces for connecting a plurality of processor chips within a limited space.

The circuit board 100 of the first embodiment may include a through electrode 140. The through electrode 140 may penetrate the insulating layer 110. Preferably, the through electrode 140 may penetrate the insulating layer 110 to electrically connect between the first circuit pattern layer 120 and the second circuit pattern layer 130. At this time, when the circuit board 100 has a multi-layer structure, the through electrode 140 may be spaced apart in a vertical direction and electrically connect between adjacent circuit pattern layers.

Meanwhile, the first circuit pattern layer 120 and the second circuit pattern layer 130 may be formed of a metal material having high electrical conductivity as a wiring for transmitting an electrical signal. To this end, the first circuit pattern layer 120 and the second circuit pattern layer 130 may be formed of at least one metal material selected from gold (Au), silver (Ag), platinum (Pt), titanium (Ti), tin (Sn), copper (Cu), and zinc (Zn). In addition, the first circuit pattern layer 120 and the second circuit pattern layer 130 may be formed of a paste or solder paste including at least one metal material selected from gold (Au), silver (Ag), platinum (Pt), titanium (Ti), tin (Sn), copper (Cu), and zinc (Zn) with excellent bonding strength. Preferably, the first circuit pattern layer 120 and the second circuit pattern layer 130 may be formed of copper (Cu) that has high electrical conductivity and is relatively inexpensive.

The first circuit pattern layer 120 and the second circuit pattern layer 130 may be formed by a conventional printed circuit board manufacturing process, such as an additive process, a subtractive process, an MSAP (Modified Semi Additive Process), and an SAP (Semi Additive Process), and a detailed description thereof will be omitted here.

A thickness (T1, see FIG. 5) of the first circuit pattern layer 120 can satisfy a range of 5 um to 30 um. Preferably, the thickness T1 of the first circuit pattern layer 120 can satisfy a range of 6 um to 25 um. More preferably, the thickness T1 of the first circuit pattern layer 120 can have a thickness in a range of 7 um to 20 um. The thickness T1 of the first circuit pattern layer 120 can mean a vertical distance from the lower surface to the upper surface of the first circuit pattern layer 120. In this case, when the upper or lower surface of the first circuit pattern layer 120 has a step, the thickness T1 of the first circuit pattern layer 120 can mean a vertical distance from a lowermost to an uppermost end of the first circuit pattern layer 120. However, the embodiment is not limited thereto. For example, the thickness T1 of the first circuit pattern layer 120 may mean an average thickness in an entire region of the first circuit pattern layer 120.

If the thickness T1 of the first circuit pattern layer 120 is smaller than 5 um, a resistance of the circuit pattern may increase, and thus the signal transmission efficiency may decrease. For example, if the thickness T1 of the first circuit pattern layer 120 is smaller than 5 um, the signal transmission loss may increase. For example, if the thickness T1 of the first circuit pattern layer 120 exceeds 30 um, a line width of the first circuit pattern layer 120 may increase, and thus the circuit integration may decrease.

Meanwhile, a thickness of the second circuit pattern layer 130 may correspond to the thickness T1 of the first circuit pattern layer 120.

The through electrode 140 may be formed by filling an inside of the through hole penetrating the insulating layer 110 with a conductive material.

The through hole can be formed by any one of mechanical, laser, and chemical processing methods. When the through hole is formed by mechanical processing, methods such as milling, drilling, and routing can be used. In addition, when the through hole is formed by laser processing, a UV or CO2 laser method can be used. In addition, when the through hole is formed by chemical processing, a chemical agent including amino silane, ketones, etc. can be used.

Meanwhile, the circuit board 100 of the first embodiment can include a protective layer.

For example, the circuit board 100 can include a first protective layer 150 disposed on an insulating layer 110. For example, the circuit board 100 can include a second protective layer 160 disposed under the insulating layer 110.

The first protective layer 150 and the second protective layer 160 can be a resist layer. Preferably, the first protective layer 150 and the second protective layer 160 may be a solder resist layer including an organic polymer material. For example, the first protective layer 150 and the second protective layer 160 may include an epoxy acrylate series resin. In detail, the first protective layer 150 and the second protective layer 160 may include a resin, a hardener, a pigment, a solvent, a filler, an additive, an acrylic series monomer, etc.

A thickness of each of the first protective layer 150 and the second protective layer 160 may be greater than a thickness of each of the first circuit pattern layer 120 and the second circuit pattern layer 130.

In other words, a thickness of the first protective layer 150 may be greater than a thickness of the first circuit pattern layer. In addition, a thickness of the second protective layer 160 may be greater than a thickness of the second circuit pattern layer 130.

The thickness of the first protective layer 150 may mean a vertical distance from a lower surface to an upper surface of the first protective layer 150 in a region that does not include an open portion of the first protective layer 150. For example, the thickness of the first protective layer 150 may mean a thickness (T4, see FIG. 5) in a second region (R2, see FIG. 5) of the first protective layer 150.

The thickness T4 of the first protective layer 150 may satisfy a range of 6.7 um to 35.0 um. Preferably, the thickness T1 of the first protective layer 150 may satisfy a range of 7.3 um to 32 um. More preferably, the thickness T1 of the first protective layer 150 may satisfy a range of 8.0 um to 30 um.

If the thickness of the first protective layer 150 exceeds 30 um, the thickness of the circuit board and the thickness of the semiconductor package may increase. In addition, if the thickness of the first protective layer 150 is smaller than 6.7 um, the first circuit pattern layer may not be stably protected, and thus the electrical reliability or physical reliability may be deteriorated.

In addition, the second protective layer 160 may have a thickness corresponding to the thickness of the first protective layer 150, but is not limited thereto.

Meanwhile, the first protective layer 150 includes at least one open portion. In addition, the second protective layer 160 includes at least one open portion.

The first protective layer 150 may include a first open portion OP1. For example, the first protective layer 150 may include a first open portion OP1 vertically overlapping the first circuit pattern 120-1.

In addition, the first protective layer 150 may include a second open portion OP2. For example, the first protective layer 150 may include a second open portion OP2 vertically overlapping the second circuit pattern 120-2.

In addition, the second protective layer 160 may include at least one third open portion vertically overlapping the second circuit pattern layer 130.

In addition, the first protective layer 150 may be divided into a plurality of regions.

The first protective layer 150 may include a first region R1 including the first open portion OP1. In addition, the first protective layer 150 may include a second region R2 adjacent to the first region R1 without including the first open portion OP1.

In addition, the first protective layer 150 may include a third region R3 including the second open portion OP2. In addition, the first protective layer 150 may include a fourth region R4 adjacent to the third region R3 without including the second open portion OP2.

At this time, the second region R2 and the fourth region R4 are regions that do not include the first open portion OP1 and the second open portion OP2. In addition, the second region R2 and the fourth region R4 in the first protective layer 150 may form a single region connected to each other. Therefore, some regions of the first protective layer 150 may mean either the second region R2 and the fourth region R4, or alternatively, may mean both the second region R2 and the fourth region R4.

Hereinafter, shapes of the first circuit pattern 120-1 and the second circuit pattern 120-2, together with the first open portion OP1 and the second open portion OP2 formed in the first protective layer 150, will be specifically described.

Referring to FIG. 5, the first protective layer 150 includes the first open portion OP1.

The first open portion OP1 may correspond to the first circuit pattern 120-1. Specifically, the first protective layer 150 may include the first open portion OP1 vertically overlapping the first circuit pattern 120-1.

The first open portion OP1 may refer to a region exposing an upper surface of the first circuit pattern 120-1 in the first region R1 of the first protective layer 150. For example, the first open portion OP1 may refer to a region vertically overlapping the first circuit pattern 120-1 in the first region R1 of the first protective layer 150.

At this time, a thickness T3 of the first region R1 of the first protective layer 150 is smaller than a thickness T1 of the first circuit pattern 120-1. Accordingly, the first open portion OP1 may mean a region in which the first protective layer 150 is not disposed by the first circuit pattern 120-1 in a region in which the first circuit pattern 120-1 is disposed.

Therefore, the width of the first open portion OP1 of the first protective layer 150 may correspond to a width of the first circuit pattern 120-1. Here, the corresponding meaning may mean that a difference between the width of the first open portion OP1 of the first protective layer 150 and the width of the first circuit pattern 120-1 is 2 µm or less, 1.5 µm or less, 1.0 µm or less, 0.8 µm or less, or 0.5 µm or less.

Preferably, the first protective layer 150 is formed by performing a process of thinning the first protective layer 150 to a thickness less than the thickness of the first circuit pattern 120-1 in a state where the upper surface of the first circuit pattern 120-1 is covered. At this time, the thinned region may be referred to as the first region R1 of the first protective layer 150. In addition, the first open portion OP1 may mean a region (or a region vertically overlapping with the first circuit pattern) in which the circuit pattern 120-1 is disposed among the thinned first region R1 of the first protective layer 150. Accordingly, a width of the first open portion OP1 of the first protective layer 150 may be the same as a width of the first circuit pattern 120-1. Preferably, the width of the first open portion OP1 of the first protective layer 150 may be the same as a width of a lower surface of the first circuit pattern 120-1. Accordingly, the first protective layer 150 may be disposed to cover a part of the side surface of the first circuit pattern 120-1 while including the first open portion OP1.

Specifically, the first protective layer 150 may be divided into a plurality of regions based on a position where the first open portion OP1 is formed.

For example, the first protective layer 150 includes a first region R1 including the first open portion OP1 and adjacent to the first open portion OP1. In addition, the first protective layer 150 may include a second region R2 adjacent to the first region R1 and having a step from the first region R1.

The first region R1 of the first protective layer 150 includes a first open portion OP1 vertically overlapping the first circuit pattern 120-1. Preferably, the first region R1 of the first protective layer 150 includes a first open portion OP1 having the same width as a lower surface of the first circuit pattern 120-1.

A height of an upper surface of the first region R1 of the first protective layer 150 is different from a height of an upper surface of the second region R2. Preferably, a thickness T3 of the first region R1 of the first protective layer 150 is smaller than a thickness T4 of the second region R2 of the first protective layer 150.

The thickness T3 of the first region R1 of the first protective layer 150 may be determined based on a thickness T1 of the first circuit pattern 120-1. Preferably, the thickness T3 of the first region R1 of the first protective layer 150 is smaller than the thickness T1 of the first circuit pattern 120-1.

For example, the thickness T3 of the first region R1 of the first protective layer 150 may satisfy a range of 20% to 90% of the thickness T1 of the first circuit pattern 120-1. Preferably, the thickness T3 of the first region R1 of the first protective layer 150 may satisfy a range of 25% to 85% of the thickness T1 of the first circuit pattern 120-1. More preferably, the thickness T3 of the first region R1 of the first protective layer 150 can satisfy a range of 27% to 83% of the thickness T1 of the first circuit pattern 120-1.

If the thickness T3 of the first region R1 of the first protective layer 150 is smaller than 20% of the thickness T1 of the first circuit pattern 120-1, the physical and/or electrical reliability of the first circuit pattern 120-1 may be deteriorated. Specifically, the first region R1 of the first protective layer 150 can have a function of supporting the pad 120-11 and/or trace 120-12 of the first circuit pattern 120-1, which is a fine pattern. In addition, if the thickness T3 of the first region R1 of the first protective layer 150 is smaller than 20% of the thickness T1 of the first circuit pattern 120-1, an effect of the support function may be insignificant.

In addition, if the thickness T3 of the first region R1 of the first protective layer 150 exceeds 90% of the thickness T1 of the first circuit pattern 120-1, residual resin of the first protective layer 150 may exist on a part of the upper surface of the first circuit pattern 120-1. In addition, if the residual resin of the first protective layer 150 exists on the upper surface of the first circuit pattern 120-1, the electrical reliability of the first circuit pattern 120-1 may be deteriorated.

At this time, the first region R1 of the first protective layer 150 is disposed to cover a part of a side surface of the first circuit pattern 120-1.

At this time, the first circuit pattern 120-1 may include a region whose width changes toward an upper surface of the first circuit pattern 120-1. Preferably, the first circuit pattern 120-1 may include a region whose width decreases an upper surface of the first circuit pattern 120-1. At this time, in the first circuit pattern 120-1, a position where the width begins to decrease may be positioned lower than the upper surface of the first region R1 of the first protective layer 150.

Accordingly, at least a part of an inner side surface of the first region R1 of the first protective layer 150 (preferably, a sidewall of the first open portion OP1 formed in the first region R1) may not be in contact with a side surface of the first circuit pattern 120-1. For example, a crevice may be formed between the inner side surface of the first region R1 of the first protective layer 150 and the outer side surface of the first circuit pattern 120-1. Specifically, the inner side surface of the first region R1 of the first protective layer 150 may include a first inner side surface adjacent to the lower surface of the first region R1 of the first protective layer 150 and in contact with the outer side surface of the first circuit pattern 120-1. In addition, the inner side surface of the first region R1 of the first protective layer 150 may include a second inner side surface adjacent to the upper surface of the first region R1 of the first protective layer 150 and not in contact with or spaced apart from the outer side surface of the first circuit pattern 120-1. In addition, the crevice may be provided between the outer side surface of the first circuit pattern 120-1 and the second inner side surface of the first region R1 of the first protective layer 150.

At this time, the crevice may not be formed by the second inner side surface of the first region R1 of the first protective layer 150, but may be formed by the outer side surface of the first circuit pattern 120-1. For example, the crevice may be provided by at least a portion of the outer side surface of the first circuit pattern 120-1 being cut inwardly. However, the embodiment is not limited thereto. For example, the crevice may be formed by the second inner side surface of the first region R1 of the first protective layer 150 being cut inwardly, or may be formed by a combination of these.

However, the following description will assume that the crevice is formed by a portion of the outer side surface of the first circuit pattern 120-1 being cut inwardly.

The first inner side surface and the second inner side surface of the first region R1 of the first protective layer 150 are connected to each other. At this time, a slope of the first inner side surface of the first region R1 of the first protective layer 150 may correspond to a slope of the second inner side surface. For example, the first and second inner side surfaces of the first region R1 of the first protective layer 150 may have a vertical slope with respect to the lower surface of the first region R1 of the first protective layer 150.

The first circuit pattern 120-1 may be divided into a plurality of parts in a thickness direction. For example, the pad 120-11 and/or the trace 120-12 of the first circuit pattern 120-1 may be divided into a plurality of parts in the thickness direction.

The first circuit pattern 120-1 may include a first part 120-1a adjacent to an upper surface of the insulating layer 110. The width of the upper surface of the first part 120-1a of the first circuit pattern 120-1 may correspond to a width of the lower surface of the first part 120-1a. Here, corresponding may mean that a width difference between an upper surface and a lower surface of the first part 120-1a of the first circuit pattern 120-1 is 2 um or less, 1.5 um or less, 1.0 um or less, 0.8 um or less, or 0.5 um or less.

A width of the first part 120-1a of the first circuit pattern 120-1 may correspond to a width of the first open portion OP1 formed in the first region R1 of the first protective layer 150. Preferably, the width of the first part 120-1a of the first circuit pattern 120-1 may be the same as the width of the first open portion OP1.

Therefore, an outer side surface 120-1as of the first part 120-1a of the first circuit pattern 120-1 can be in direct contact with the first protective layer 150. Preferably, the outer side surface 120-1as of the first part 120-1a of the first circuit pattern 120-1 can be in direct contact with the first inner side surface of the first region R1 of the first protective layer 150.

The outer side surface 120-1as of the first part 120-1a of the first circuit pattern 120-1 can have a slope corresponding to the slope of the first inner side surface of the first region R1 of the first protective layer 150. For example, the outer side surface of the first part 120-1a of the first circuit pattern 120-1 may be perpendicular to the lower surface of the first circuit pattern 120-1, but is not limited thereto.

At this time, an uppermost end of the first part 120-1a of the first circuit pattern 120-1 may be positioned lower than an upper surface of the first region R1 of the first protective layer 150. For example, a thickness T2 of the first part 120-1a of the first circuit pattern 120-1 may be smaller than a thickness T3 of the first region R1 of the first protective layer 150.

At this time, the thickness T2 of the first part 120-1a of the first circuit pattern 120-1 can be determined by the thickness T3 of the first region R1 of the first protective layer 150.

Specifically, the thickness T2 of the first part 120-1a of the first circuit pattern 120-1 can satisfy a range of 20% to 90% of the thickness T3 of the first region R1 of the first protective layer 150. Preferably, the thickness T2 of the first part 120-1a of the first circuit pattern 120-1 can satisfy a range of 25% to 85% of the thickness T3 of the first region R1 of the first protective layer 150. More preferably, the thickness T2 of the first part 120-1a of the first circuit pattern 120-1 can satisfy a range of 27% to 83% of the thickness T3 of the first region R1 of the first protective layer 150.

If the thickness T2 of the first part 120-1a of the first circuit pattern 120-1 is smaller than 20% of the thickness T3 of the first region R1 of the first protective layer 150, a contact area between the outer side surface of the first circuit pattern 120-1 and the inner side surface of the first region R1 of the first protective layer 150 decreases, and thus the physical reliability and/or electrical reliability of the first circuit pattern 120-1 may deteriorate. In addition, if the thickness T2 of the first part 120-1a of the first circuit pattern 120-1 is smaller than 20% of the thickness T3 of the first region R1 of the first protective layer 150, a depth of the crevice increases, and thus the physical reliability of a connection part disposed on the first circuit pattern 120-1 may deteriorate. For example, if the depth of the crevice increases, a thickness deviation of the connection part increases, and thus the mounting processability of the semiconductor device may deteriorate. In addition, if the depth of the crevice increases, an amount of the connection part increases, and thus a rigidity of the connection part may deteriorate.

In addition, if the thickness T2 of the first part 120-1a of the first circuit pattern 120-1 exceeds 90% of the thickness T3 of the first region R1 of the first protective layer 150, the depth of the crevice may decrease, and thus an effect provided by the crevice may be insufficient. For example, the crevice is formed to increase a distance between a lowermost end of a surface treatment layer (170, see FIG. 6) disposed on the first circuit pattern 120-1 and an upper surface of the second region R2 of the first protective layer 150. At this time, if the thickness T2 of the first part 120-1a of the first circuit pattern 120-1 exceeds 90% of the thickness T3 of the first region R1 of the first protective layer 150, the distance increasing effect is insufficient, and thus, a physical reliability problem, such as a crack occurring in the intermetallic compound formed by arranging the connection part, may occur.

Meanwhile, the first circuit pattern 120-1 includes a second part 120-1b disposed on the first part 120-1a. An upper surface of the second part 120-1b is positioned higher than the upper surface of the first region R1 of the first protective layer 150. In addition, a lower surface of the second part 120-1b is positioned lower than the upper surface of the first region R1 of the first protective layer 150.

The second part 120-1b of the first circuit pattern 120-1 includes a region whose width changes.

Specifically, a width of the second part 120-1b of the first circuit pattern 120-1 may decrease as it moves away from the first part 120-1a.

For example, the second part 120-1b of the first circuit pattern 120-1 includes an outer side surface 120-1bs connected to the outer side surface 120-1as of the first part 120-1a.

The outer side surface 120-1bs of the second part 120-1b has a slope different from the slope of the outer side surface 120-1as of the first part 120-1a. For example, the outer side surface 120-1as of the first part 120-1a may have a slope with no change in width.

In addition, the outer side surface 120-1bs of the second part 120-1b may have a slope whose width gradually decreases as it moves away from the first portion 120-1a.

For example, the outer side surface 120-1bs of the second part 120-1b may be a straight line with a specific slope in which the width of the second part gradually decreases. At this time, in FIG. 5, the outer side surface 120-1bs of the second part 120-1b is illustrated as a straight line with a specific slope, but is not limited thereto. For example, the outer side surface 120-1bs of the second part 120-1b may have a specific curvature in which the width of the second part decreases toward the upper surface of the second part. In addition, the outer side surface 120-1bs of the second part 120-1b having the curvature may have a convex shape toward the first region R1 of the first protective layer 150, and differently, may have a concave shape toward an inner side of the second pad 120-1b away from the first region R1 of the first protective layer 150.

The outer side surface 120-1bs of the second part 120-1b does not contact the first protective layer 150. For example, the outer side surface 120-1bs of the second part 120-1b does not contact the inner side surface of the first region R1 of the first protective layer 150. For example, the outer side surface 120-1bs of the second part 120-1b is spaced from the inner side surface of the first region R1 of the first protective layer 150. For example, a crevice is formed between the outer side surface 120-1bs of the second part 120-1b and the inner side surface of the first region R1 of the first protective layer 150.

In addition, the embodiment can improve the physical reliability and/or electrical reliability of the circuit board and the semiconductor package including the same by using the crevice formed between the first circuit pattern 120-1 and the first protective layer 150.

For example, referring to FIG. 6, a surface treatment layer 170 is disposed on the first circuit pattern 120-1. The surface treatment layer 170 may be an organic solderability preservative (OSP).

At this time, the surface treatment layer 170 is disposed on a surface of the first circuit pattern 120-1. For example, the surface treatment layer 170 is disposed on the surface of the circuit pattern 120-1 exposed through the first open portion OP1 of the first protective layer 150. For example, the surface treatment layer 170 is disposed on the upper surface and the outer side surface 120-1bs of the second part 120-1b of the first circuit pattern 120-1. Accordingly, a lowermost end of the surface treatment layer 170 is located within the crevice formed between the first circuit pattern 120-1 and the first region R1 of the first protective layer 150. Through this, the embodiment can increase a distance or length of the side wall of the first protective layer 150 between the upper surface of the second region R2 of the first protective layer 150 and the lowermost end of the surface treatment layer 170. Therefore, the embodiment can improve the physical reliability and/or electrical reliability of the intermetallic compound formed by disposing a connection part such as a solder on the surface treatment layer 170.

Meanwhile, the crevice can be formed by preprocessing a part of the upper surface and the outer side surface of the first circuit pattern 120-1 during the process of forming the surface treatment layer 170. For example, in a process of preprocessing, the upper surface and the outer side surface 120-1bs of the second part 120-1b of the first circuit pattern 120-1 can be etched. Therefore, a crevice may be formed between the outer side surface 120-1bs of the second part 120-1b and the inner side surface of the first region R1 of the first protective layer 150 due to the etching.

Therefore, the outer side surface of the first circuit pattern 120-1 may have different roughnesses depending on a region.

For example, the outer side surface 120-1as of the first part 120-1a of the first circuit pattern 120-1 may have a first surface roughness. At this time, the first surface roughness of the outer side surface 120-1as of the first part 120-1a may correspond to the surface roughness of the inner side surface of the first region R1 of the first protective layer 150 in contact with the outer side surface 120-1as of the first part 120-1a.

Meanwhile, the outer side surface 120-1bs of the second part 120-1b of the first circuit pattern 120-1 may have a second surface roughness different from the first surface roughness. Preferably, the outer side surface 120-1bs of the second part 120-1b of the first circuit pattern 120-1 may have a second surface roughness greater than the first surface roughness of the outer side surface 120-1as of the first part 120-1a.

Through this, the embodiment can secure adhesion between the surface treatment layer 170 and the first circuit pattern 120-1, and thus improve the physical reliability and/or electrical reliability of the circuit board and the semiconductor package including the same.

Meanwhile, the first protective layer 150 may include a recessed portion 153. The recessed portion 153 may be formed at a boundary between the first region R1 and the second region R2 of the first protective layer 150. The recessed portion 153 may be formed at the boundary in a process of thinning the thickness T3 of the first region R1 of the first protective layer 150. For example, the recessed portion 153 may be formed at the boundary between the first region R1 and the second region R2 because the first protective layer 150 is not completely cured. In addition, the embodiment may minimize a length of the recessed portion 153 in a horizontal direction by controlling the thickness T3 of the first region R1.

However, the embodiment allows the recessed portion 153 to be provided at the boundary with a certain level of length in a horizontal direction by adjusting the thickness T3 of the first region R1. Then, the recessed portion 153 can be filled with a connection part such as a solder in a subsequent solder bonding process. In addition, the connection part disposed within the recessed portion 153 can function as an anchor, thereby improving a bonding strength between the connection part and the first circuit pattern 120-1.

Meanwhile, referring to FIG. 7, the first protective layer 150 includes a second open portion OP2. At this time, the second open portion OP2 may have a different shape from the first open portion OP1. For example, the second open portion OP2 may be an SMD type open portion.

For example, the second open portion OP2 vertically overlaps the second circuit pattern 120-2. At this time, the second open portion OP2 partially vertically overlaps an upper surface of the second circuit pattern 120-2. For example, a part of the upper surface of the second circuit pattern 120-2 may be covered by the first protective layer 150, and a remaining part of the upper surface of the second circuit pattern 120-2 may be exposed through the second open portion OP2.

At this time, the first protective layer 150 may include a third region R3 including the second open portion OP2 and adjacent to the second open portion OP2. The third region R3 may mean a region including the second open portion OP2 and vertically overlapping the second circuit pattern 120-2. In addition, the first protective layer 150 may include a fourth region R4 adjacent to the third region R3. At this time, an upper surface of the third region R3 of the first protective layer 150 may have the same height as the upper surface of the fourth region R4. For example, the upper surface of the third region R3 of the first protective layer 150 may not have a step from the upper surface of the fourth region R4. For example, the upper surface of the third region R3 of the first protective layer 150 may be located on the same plane as the upper surface of the fourth region R4. That is, the second circuit pattern 120-2 is a large-area pattern compared to the first circuit pattern 120-1. Therefore, even if the second open portion OP2 vertically overlapping the second circuit pattern 120-2 does not have the same structure as the first open portion OP1, the reliability of the intermetallic compound can be maintained.

Therefore, the second circuit pattern 120-2 may include a recess 120-2R formed by etching a portion of the upper surface of the second circuit pattern 120-2 in a pretreatment process for forming a surface treatment layer (not shown). In addition, a width of the recess 120-2R in the horizontal direction may be larger than the width of the second open portion OP2. For example, a part of the recess 120-2R vertically overlaps with the second open portion OP2, and the remaining part of the recess 120-2R vertically overlaps with the third region R3 of the first protective layer 150. Accordingly, a surface treatment layer or a connection part such as a solder, can penetrate into the recess 120-2R. Through this, the embodiment can enable the surface treatment layer or connection part that penetrates into the recess 120-2R to function as an anchor, thereby further enhancing the bonding strength between the second circuit pattern 120-2 and the surface treatment layer or the solder.

The embodiment includes an insulating layer, a first circuit pattern disposed on the insulating layer, and a first protective layer disposed on the insulating layer and including a first open portion vertically overlapping the first circuit pattern.

That is, the first protective layer includes a first region adjacent to the first open portion and including the first open portion. In addition, the first protective layer includes a second region adjacent to the first region. At this time, a height of an upper surface of the first region is lower than a height of an upper surface of the second region. Preferably, the height of the upper surface of the first region is lower than a height of an upper surface of the first circuit pattern. Accordingly, the embodiment arranges the first protective layer including the first region having the first open portion and the second region in a region where the protective layer is not disposed due to an exposure resolution of the protective layer. In addition, the first region is disposed surrounding the first circuit pattern while including the first open portion having substantially a same width as the first circuit pattern.

Accordingly, the embodiment can stably protect the first circuit pattern from damage caused by various stresses. Accordingly, the embodiment can improve physical reliability and/or electrical reliability of the first circuit pattern.

At this time, a crevice can be formed between an inner side surface of the first region of the first protective layer and an outer side surface of the first circuit pattern.

Specifically, the inner side surface of the first region includes a first inner side surface in contact with an outer side surface of the first circuit pattern and a second inner side surface spaced apart from the outer side surface of the first circuit pattern by the crevice without contacting the outer side surface of the first circuit pattern.

In addition, the embodiment allows a surface treatment layer and/or solder to be disposed in the crevice. Accordingly, the embodiment can increase a distance between an intermetallic compound formed by disposing a solder and an uppermost surface of the first protective layer. Accordingly, the embodiment can drastically reduce the occurrence of cracks in the intermetallic compound, thereby improving the physical reliability and/or electrical reliability of a circuit board and a semiconductor package.

Furthermore, the embodiment can increase the distance by using the clevis without increasing a thickness of the first protective layer. Therefore, the embodiment can realize slimming of the circuit board and the semiconductor package.

In addition, the outer side surface of the first circuit pattern includes a first outer side surface that contacts the outer side surface of the first region of the first protective layer, and a second outer side surface that does not contact the first protective layer. In addition, a surface roughness of the second outer side surface can be greater than a surface roughness of the first outer side surface. Accordingly, the embodiment can secure adhesion between a surface treatment layer disposed on the second outer side surface and the first circuit pattern, and thereby improve the physical reliability and/or electrical reliability of the circuit board and the semiconductor package including the same.

In addition, the embodiment allows a recessed portion to be formed inwardly at a boundary between the first region and the second region by controlling a thickness of the first region. In addition, the recessed portion can be filled with a connection part, such as solder, in a process of bonding the solder. In addition, the connection part disposed in the recessed portion can function as an anchor, thereby improving a bonding strength between the connection part and the first circuit pattern.

Hereinafter, a circuit board according to another embodiment will be described.

A circuit board described below is similar to the first circuit board embodiment illustrated in FIG. 5, and may differ in a shape of the first circuit pattern. Therefore, a description of the circuit board of another embodiment below will focus on a shape of the first circuit pattern.

FIG. 8 is a view showing a circuit board according to a second embodiment.

Referring to FIG. 8, the circuit board of the second embodiment includes an insulating layer 210, a first circuit pattern 220-1, and a first protective layer 250.

The first protective layer 250 includes a first open portion OP1. For example, the first protective layer 250 includes a first region R1 including the first open portion OP1 and adjacent to the first open portion OP1. In addition, the first protective layer 250 may include a second region R2 adjacent to the first region R1 and having a step from the first region R1.

In addition, the first circuit pattern 220-1 includes a first part 220-1a and a second part 220-1b.

Here, the insulating layer 210 and the first protective layer 250 have the same structure as the insulating layer 110 and the first protective layer 150 of the first embodiment. Accordingly, the description thereof will be omitted.

The first part 220-1a of the first circuit pattern 220-1 has the same structure as the first part 120-1a of the first circuit pattern 110-1 of the first embodiment. Accordingly, the description thereof will also be omitted.

Meanwhile, the second part 220-1b of the first circuit pattern 220-1 is disposed on the first part 220-1a. At this time, the second part 220-1b may have a step with the first part 220-1a.

Specifically, the first part 120-1a in the first embodiment did not have a step with the second part 120-1b. That is, in the first embodiment, a width of the first part 120-1a at a portion closest to the second part 120-1b is the same as a width of the second part 120-1b at a portion closest to the first part 120-1a.

Unlike this, the second part 220-1b in the second embodiment may have a step with the first part 220-1a. Specifically, a width of the second part 220-1b at a portion closest to the first part 220-1a may be different from a width of the first part 220-1a at a portion closest to the second part 220-1b. More specifically, a width of the second part 220-1b at a portion closest to the first part 220-1a is smaller than a width of the first part 220-1a at a portion closest to the second part 220-1b.

Accordingly, a step portion 220-1ST may be provided between the first part 220-1a and the second part 220-1b of the first circuit pattern 220-1. The step portion 220-1ST may mean a portion where a part of the upper surface of the first part 220-1a is exposed due to a difference in width between the first part 220-1a and the second part 220-1a of the first circuit pattern 220-1. That is, the upper surface of the first part 220-1a does not contact the second part 220-1b and the first protective layer 250.

In addition, the outer side surface 220-1bs of the second part 220-1b may have a slope whose width gradually decreases as it moves away from the first part 220-1a.

For example, the outer side surface 220-1bs of the second part 220-1b may be a straight line having a specific slope whose width gradually decreases, but is not limited thereto.

For example, the outer side surface 220-1bs of the second part 220-1b may have a specific curvature whose width decreases toward the upper surface. In addition, the outer side surface 220-1bs of the second part 220-1b having the curvature may have a convex shape toward an outside, or alternatively may have a concave shape toward an inside.

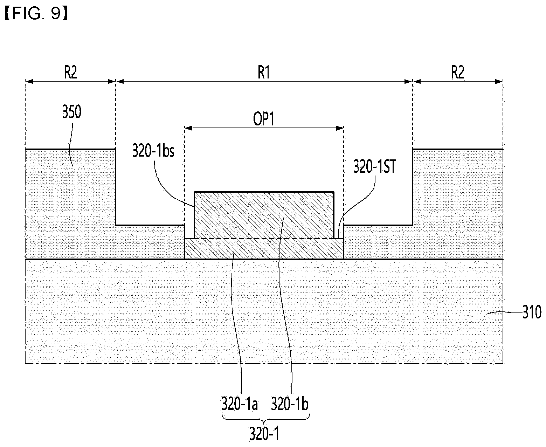

FIG. 9 is a view showing a circuit board according to a third embodiment.

Referring to FIG. 9, the circuit board of the third embodiment includes an insulating layer 310, a first circuit pattern 320-1, and a first protective layer 350.

The first protective layer 350 includes a first open portion OP1. For example, the first protective layer 350 includes a first region R1 including the first open portion OP1 and adjacent to the first open portion OP1. In addition, the first protective layer 350 may include a second region R2 adjacent to the first region R1 and having a step from the first region R1.

In addition, the first circuit pattern 320-1 includes a first part 320-1a and a second part 320-1b.

Here, the insulating layer 310 and the first protective layer 350 have the same structure as the insulating layer 110 and the first protective layer 150 of the first embodiment. Accordingly, the description thereof will be omitted.

The first part 320-1a of the first circuit pattern 320-1 has the same structure as the first part 120-1a of the first circuit pattern 110-1 of the first embodiment. Accordingly, the description thereof will also be omitted.

Meanwhile, the second part 320-1b of the first circuit pattern 320-1 is disposed on the first part 320-1a. At this time, the second part 320-1b may have a step with the first part 320-1a.

That is, a width of the second part 320-1b at a portion closest to the first part 320-1a may be different from a width of the first part 320-1a at a portion closest the second part 320-1b. Specifically, the width of the second part 320-1b at a portion closest to the first part 320-1a is smaller than the width of the first part 320-1a at a portion closest to the second part 320-1b.

Accordingly, a step portion 320-1ST may be provided between the first part 320-1a and the second part 320-1b of the first circuit pattern 320-1. The step portion 320-1ST may mean a portion where a portion of the upper surface of the first part 320-1a is exposed due to a difference in width between the first part 320-1a and the second part 320-1a of the first circuit pattern 320-1. That is, the upper surface of the first part 320-1a does not contact the second part 320-1b and the first protective layer 350.

In addition, the width of the second part 320-1b may not change as the distance from the first part 320-1a increases. For example, the outer side surface 320-1bs of the second part 320-1b may be a straight line perpendicular to the lower surface of the first circuit pattern 320-1 without a change in width.

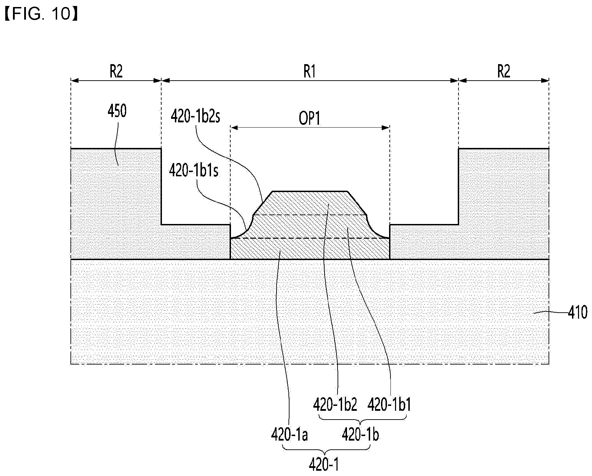

FIG. 10 is a view showing a circuit board according to a fourth embodiment.

Referring to FIG. 10, the circuit board of the fourth embodiment includes an insulating layer 410, a first circuit pattern 420-1, and a first protective layer 450.

The first protective layer 450 includes a first open portion OP1. For example, the first protective layer 450 includes a first region R1 including the first open portion OP1 and adjacent to the first open portion OP1. In addition, the first protective layer 450 may include a second region R2 adjacent to the first region R1 and having a step from the first region R1.

In addition, the first circuit pattern 420-1 includes a first part 420-1a and a second part 420-1b.

Here, the insulating layer 410 and the first protective layer 450 have the same structure as the insulating layer 110 and the first protective layer 150 of the first embodiment. Accordingly, the description thereof will be omitted.

The first part 420-1a of the first circuit pattern 420-1 has the same structure as the first part 120-1a of the first circuit pattern 110-1 of the first embodiment. Accordingly, the description thereof will also be omitted.

Meanwhile, the second part 420-1b of the first circuit pattern 420-1 is disposed on the first part 420-1a.

At this time, the second part 420-1b may be divided into a plurality of sub-parts.

For example, the second part 420-1b may be divided into a plurality of sub-parts based on a shape or an inclination of the outer side surface.

The second part 420-1b includes a first sub-part 420-1b1 disposed on the first part 420-1a. In addition, the second part 420-1b may include a second sub-part 420-1b2 disposed on the first sub-part 420-1b1.

At this time, vertical cross sections of the first sub-part 420-1b1 and the second sub-part 420-1b2 may have different shapes. For example, outer side surfaces of the first sub-part 420-1b1 and the second sub-part 420-1b2 may have different slopes.

An outer side surface 420-1b1s of the first sub-part 420-1b1 may be a curve having a specific curvature. Accordingly, a width of the first sub-part 420-1b1 may decrease as it moves away from the first part 420-1a based on the curvature of the curve. In addition, an outer side surface 420-1b1s of the first sub-part 420-1b1 having the curvature may have an outwardly convex shape, or, differently, may have an inwardly concave shape.

In addition, the outer side surface 420-1b2s of the second sub-part 420-1b2 may have a slope whose width gradually decreases as it moves away from the first sub-part 420-1b1.

For example, the outer side surface 420-1b2s of the second sub-part 420-1b2) may be a straight line having a specific slope whose width gradually decreases, but is not limited thereto. For example, the outer side surface 420-1b2s of the second sub-part 420-1b2 may have a specific curvature. In addition, the outer side surface 420-1b2s of the second sub-part 420-1b2 having the curvature may have an outwardly convex shape, or, differently, may have an inwardly concave shape.

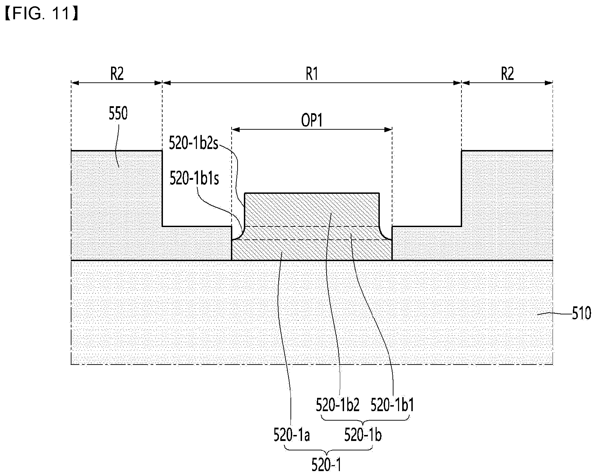

FIG. 11 is a view showing a circuit board according to a fifth embodiment.

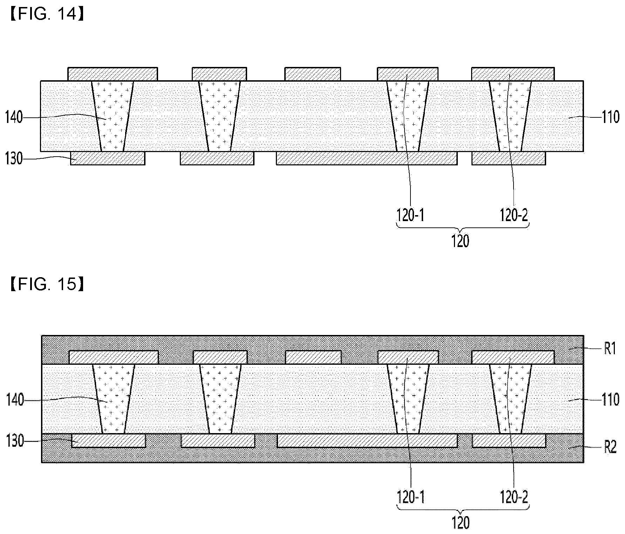

Referring to FIG. 15, the circuit board of the fifth embodiment includes an insulating layer 510, a first circuit pattern 520-1, and a first protective layer 550.

The first protective layer 550 includes a first open portion OP1. For example, the first protective layer 550 includes a first region R1 including the first open portion OP1 and adjacent to the first open portion OP1. In addition, the first protective layer 550 may include a second region R2 adjacent to the first region R1 and having a step from the first region R1.

In addition, the first circuit pattern 520-1 includes a first part 520-1a and a second part 520-1b.

Here, the insulating layer 510 and the first protective layer 550 have the same structure as the insulating layer 110 and the first protective layer 150 of the first embodiment. Accordingly, the description thereof will be omitted.

The first part 520-1a of the first circuit pattern 520-1 has the same structure as the first part 120-1a of the first circuit pattern 110-1 of the first embodiment. Accordingly, the description thereof will also be omitted.

Meanwhile, the second part 520-1b of the first circuit pattern 520-1 is disposed on the first part 520-1a.

At this time, the second part 520-1b may be divided into a plurality of sub-parts.

For example, the second part 520-1b may be divided into a plurality of sub-parts based on a shape or a slope of an outer side surface.

The second part 520-1b includes a first sub-part 520-1b1 disposed on the first part 520-1a. In addition, the second part 520-1b may include a second sub-part 520-1b2 disposed on the first sub-part 520-1b1.

At this time, vertical cross sections of the first sub-part 520-1b1 and the second sub-part 520-1b2 may have different shapes. For example, outer side surfaces of the first sub-part 520-1b1 and the second sub-part 520-1b2 may have different slopes.

An outer side surface 520-1b1s of the first sub-part 520-1b1 may be a curve having a specific curvature. Accordingly, a width of the first sub-part 520-1b1 may decrease as it moves away from the first part 520-1a based on the curvature of the curve. In addition, the outer side surface 520-1b1s of the first sub-part 520-1b1 having the curvature may have an outwardly convex shape, and differently, may have an inwardly concave shape.

A width of the second sub-part 520-1b2 may not change as it moves away from the first sub-part 520-1b1.

For example, the outer side surface 520-1b2s of the second sub-part 520-1b2 may be perpendicular to the lower surface of the first circuit pattern 520-1.

### - Semiconductor package -

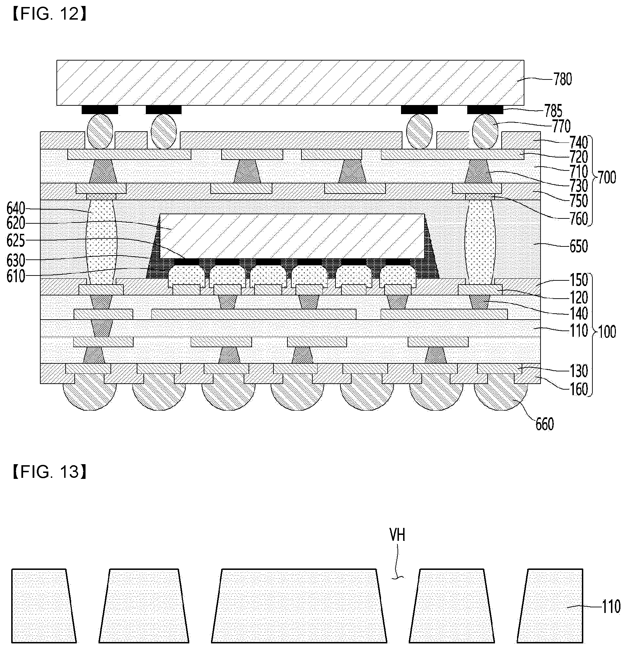

FIG. 12 is a cross-sectional view showing a semiconductor package according to an embodiment.

Referring to FIG. 12, a semiconductor package of an embodiment may include any one of the circuit boards illustrated in FIGS. 5, 8, 9, 10, and 11. In addition, the circuit board may have a multilayer structure.

The semiconductor package of the embodiment includes a first connection part 610. That is, the circuit pattern layer of the circuit pattern includes pads disposed in a mounting region of the semiconductor device 6420. The pad may mean a pad 120-11 of the first circuit pattern 120-1 of the first circuit pattern layer.

The first connection part 610 may have a hexahedral shape. A cross-section of the first connection part 610 may include a square shape. The cross-section of the first connection part 610 may include a rectangle or a square. For example, the first connection part 610 may include a spherical shape. For example, the cross-section of the first connection part 610 may include a circular shape or a semicircular shape. For example, the cross-section of the first connection part 610 may include a partially or entirely rounded shape. A cross-sectional shape of the first connection part 610 may be flat at one side and curved at other side. The first connection part 610 may be a solder ball, but is not limited thereto. Meanwhile, at least a portion of the first connection part 610 may be disposed within the crevice.

The semiconductor package of the embodiment includes a configuration disposed on the first connection part 610. The configuration disposed on the first connection part 610 may be a semiconductor device, or alternatively, an interposer. Hereinafter, the configuration disposed on the first connection part 610 is described as a semiconductor device 620.

The semiconductor device 620 may be a logic chip, but is not limited thereto. For example, the semiconductor device 620 may be an application processor (AP) chip among a central processor (e.g., a CPU), a graphic processor (e.g., a GPU), a digital signal processor, an encryption processor, a microprocessor, and a microcontroller. The semiconductor device 620 includes a terminal 625 provided at a lower surface. In addition, the terminal 625 of the semiconductor device 620 is connected to a circuit pattern layer of the circuit board through the first connection part 610.

In addition, the semiconductor package may include an underfill 630. The underfill 630 may be disposed to cover a periphery of the semiconductor device 620 on the circuit board. However, the underfill 630 may be optionally omitted. For example, the semiconductor package may perform a function of the underfill 630 in a molding layer 650 while the underfill 630 is omitted.

The semiconductor package may include a second connection part 640. The second connection part 640 is disposed on the first circuit pattern layer of the circuit board. For example, the second connection part 640 may be disposed on the second circuit pattern 120-2 of the first circuit pattern layer 120.

The second connection part 640 may be a bump. For example, the second connection part 640 may be a solder bump, but is not limited thereto. For example, the second connection part 640 may be a post bump. For example, the second connection part 640 may include a copper post and a solder bump disposed on the copper post. An upper surface of the second connection part 640 may be positioned higher than an upper surface of the semiconductor device 620. Accordingly, the semiconductor device 620 may be prevented from being damaged during a bonding process of an external substrate 600 to be disposed on the second connection part 640.

The semiconductor package may include a molding layer 650. The molding layer 650 may mold the configurations disposed on the circuit board.

The molding layer 650 may be EMC (Epoxy Mold Compound), but is not limited thereto. The molding layer 650 may have a low permittivity. For example, the permittivity (Dk) of the molding layer 650 may be 0.2 to 10. For example, the permittivity (Dk) of the molding layer 650 may be 0.5 to 8. For example, the permittivity (Dk) of the molding layer 650 may be 0.8 to 5. Accordingly, in the embodiment, the molding layer 650 may have a low permittivity, thereby improving heat dissipation characteristics of heat generated from the semiconductor device 620. The molding layer 650 may include an opening. For example, the molding layer 650 may include an opening vertically overlapping the upper surface of the second connection part 640.

The semiconductor package includes a third connection part (660).

The third connection part (660) may be disposed under a circuit pattern layer disposed at a lowermost side of the circuit board. The third connection part (660) may be a solder for connecting the semiconductor package of the embodiment to a separate external substrate (e.g., a main board of an electronic device), but is not limited thereto.

The semiconductor package includes an external substrate 700. The external substrate 700 may refer to a separate substrate that is combined with the circuit board of the embodiment. For example, the semiconductor device 620 disposed on the circuit board may be a logic chip such as a CPU or GPU, and the external substrate 700 may refer to a memory substrate on which a memory chip connected to the logic chip is disposed. The external substrate 700 may be an interposer that connects between the memory substrate on which the semiconductor device 780 corresponding to the memory chip is disposed and the circuit board.

The external substrate 700 may include an insulating layer 710, a circuit layer 720, a through electrode 730, an upper protective layer 740, and a lower protective layer 750. In addition, the external substrate 700 may include a fourth connection part 760. The fourth connection part 760 may be disposed between the external substrate 700 and the third connection part 740.

In addition, the semiconductor package may include a fifth connection part 770. The fifth connection part 770 may be disposed on the external substrate 700.

The semiconductor package may include a semiconductor device 780. The semiconductor device 780 may be mounted on the external substrate 700 through the fifth connection part 770. The semiconductor device 780 may be a memory chip, but is not limited thereto. A terminal 785 of the semiconductor device 780 may be electrically connected to the external substrate 700 through the fifth connection part 770. At this time, the semiconductor device 780 is illustrated as being mounted in a flip chip manner, but is not limited thereto. The semiconductor device 780 may be a stack memory chip, and thus may be electrically connected to the external substrate 700 through a separate connecting member such as a wire.

### - Manufacturing method -

Hereinafter, a method for manufacturing a circuit board according to an embodiment will be described.

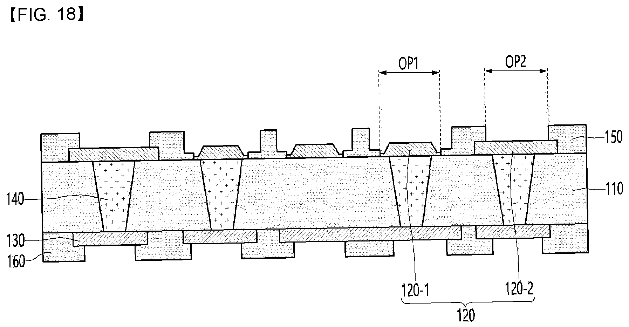

FIGS. 13 to 18 are cross-sectional views showing a method for manufacturing a circuit board according to an embodiment in orders of processes.

Referring to FIG. 13, the embodiment prepares an insulating layer 110.

Thereafter, the embodiment forms a through hole VH penetrating the upper and lower surfaces of the insulating layer 110.

Next, referring to FIG. 14, the embodiment can form a through electrode 140 filling the through hole VH on the insulating layer 110. In addition, the embodiment can form a first circuit pattern layer 120 including a first circuit pattern 120-1 and a second circuit pattern 120-2 on the upper surface of the insulating layer 110. In addition, the embodiment can form a second circuit pattern layer 130 on the lower surface of the insulating layer 120.

Thereafter, referring to FIG. 15, the embodiment forms a first resist layer R1 on the insulating layer 120. At this time, the first resist layer R1 may mean a protective layer before an open portion is formed in the first protective layer 150. The first resist layer R1 may be a solder resist layer, but is not limited thereto.

In addition, the embodiment forms a second resist layer R2 under the insulating layer 120. At this time, the second resist layer R2 may mean a protective layer before an open portion is formed in the second protective layer 160. The second resist layer R2 may be a solder resist layer, but is not limited thereto.

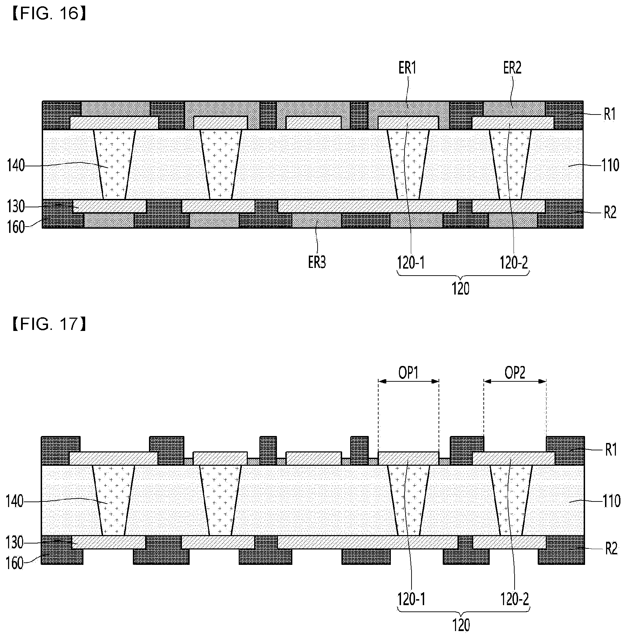

Next, referring to FIG. 16, the embodiment may perform a process of exposing the first resist layer R1 to form a first exposure pattern ER1 and a second exposure pattern ER2. The first exposure pattern ER1 and the second exposure pattern ER2 may be formed to correspond to a region in which an open portion is to be formed in the first resist layer R1.

In addition, the embodiment may perform a process of exposing the second resist layer R2 to form a third exposure pattern ER3.

Next, referring to FIG. 17, the embodiment can perform a process of curing remaining regions of the first resist layer R1 and the second resist layer R2 excluding the first to third exposure patterns ER1, ER2, and ER3 when the first to third exposure patterns ER1, ER2, and ER3 are formed. Thereafter, the embodiment can perform a thinning process of reducing the thickness of regions corresponding to the first to third exposure patterns ER1, ER2, and ER3 to a target thickness.

The thinning process can be performed using an organic alkaline compound containing tetramethylammonium hydroxide (TMAH) or trimethyl-2-hydroxyethylammonium hydroxide (choline).

Through this, the embodiment can form the first open portion OP1 and the second open portion OP2 in the first protective layer 150, respectively.

Thereafter, the embodiment may perform OSP preprocessing. Then, when the OSP preprocessing is performed, a portion of the outer side surface of the first circuit pattern 120-1 that is not covered with the first protective layer 150 may be removed by etching.

As a result, a crevice may be formed between the first protective layer 150 and the first circuit pattern 120-1. In addition, the OSP preprocessing may also be performed on the upper surface of the second circuit pattern 120-2 vertically overlapping the second open portion OP2. As a result, a recess 120-2R may be formed at the upper surface of the second circuit pattern 120-2 by the OSP preprocessing.

On the other hand, when the circuit board having the above-described characteristics of the invention is used in an IT device or home appliance such as a smart phone, a server computer, a TV, and the like, functions such as signal transmission or power supply can be stably performed. For example, when the circuit board having the features of the present invention performs a semiconductor package function, it can function to safely protect the semiconductor chip from external moisture or contaminants, or alternatively, it is possible to solve problems of leakage current, electrical short circuit between terminals, and electrical opening of terminals supplied to the semiconductor chip. In addition, when the function of signal transmission is in charge, it is possible to solve the noise problem. Through this, the circuit board having the above-described characteristics of the invention can maintain the stable function of the IT device or home appliance, so that the entire product and the circuit board to which the present invention is applied can achieve functional unity or technical interlocking with each other.

When the circuit board having the characteristics of the invention described above is used in a transport device such as a vehicle, it is possible to solve the problem of distortion of a signal transmitted to the transport device, or alternatively, the safety of the transport device can be further improved by safely protecting the semiconductor chip that controls the transport device from the outside and solving the problem of leakage current or electrical short between terminals or the electrical opening of the terminal supplied to the semiconductor chip. Accordingly, the transportation device and the circuit board to which the present invention is applied can achieve functional integrity or technical interlocking with each other.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A circuit board comprising:
an insulating layer;
a first circuit pattern disposed on the insulating layer; and
a first protective layer disposed on the insulating layer and including a first open portion vertically overlapping the first circuit pattern,
wherein the first protective layer includes a first region including the first open portion and having a first thickness, and a second region having a second thickness greater than the first thickness without including the first open portion,
wherein the first thickness of the first region is smaller than a third thickness of the first circuit pattern, and
wherein an inner side surface of the first region constituting the first open portion includes a first inner side surface in direct contact with an outer side surface of the first circuit pattern, and a second inner side surface spaced apart from the outer side surface of the first circuit pattern.

2. The circuit board of claim 1, wherein the second inner side surface of the first region is connected to the first inner side surface of the first region and has a slope corresponding to a slope of the first inner side surface.

3. The circuit board of claim 1, wherein the second thickness of the second region is greater than the third thickness of the first circuit pattern.

4. The circuit board of claim 1, wherein the first circuit pattern includes a region whose width decreases toward an upper surface of the first circuit pattern, and
wherein the second inner side surface of the first region is spaced apart from an outer side surface of the region of the first circuit pattern whose width decreases.

5. The circuit board of any one of claims 1 to 4, wherein the first thickness of the first region satisfies a range of 20% to 90% of the third thickness of the first circuit pattern.

6. The circuit board of claim 5, wherein the first circuit pattern includes:
a first part disposed on an upper surface of the insulating layer and having an outer side surface in contact with the first inner side surface of the first region; and
a second part disposed on the first part and having an outer side surface that does not contact the first protective layer, and
wherein the second part includes a region having a width smaller than a width of the first part.

7. The circuit board of claim 6, wherein a width of the first open portion corresponds to a width of the first part.

8. The circuit board of claim 6, wherein the first part has a fourth thickness in a range of 20% to 90% of the first thickness of the first region.

9. The circuit board of claim 6, wherein the outer side surface of the second part has a linear slope whose width gradually decreases toward an upper surface of the second part.

10. The circuit board of claim 6, wherein the outer side surface of the second part has a curved slope with a specific curvature whose width decreases toward an upper surface of the second part.
